# EUROPEAN PATENT SPECIFICATION

(11) **EP 0 522 461 B1**
(45) Date of publication and mention of the grant of the patent: **27.03.1996**
(21) Application number: 92111291.8
(22) Date of filing: 03.07.1992
(51) Int. Cl.: H01L 23/10, H01L 23/055

(54) **Sealed flip chip semiconductor device**
Versiegelte Flip-Chip-Halbleiteranordnung
Dispositif semi-conducteur scellé du type "Flip chip"

(30) Priority: 10.07.1991 JP 195818/91
(43) Date of publication of application: 13.01.1993
(73) Proprietor: SUMITOMO ELECTRIC INDUSTRIES, LTD., Osaka-shi, Osaka 541 (JP)
(72) Inventor: Hashinaga, Tatsuya, c/o Yokohama Works of Sumitomo, Yokohama-shi, Kanagawa-ken (JP)
(74) Representative: Grünecker, Kinkeldey, Stockmair & Schwanhäusser Anwaltssozietät

(56) References cited:
- US-A- 3 591 839
- PATENT ABSTRACTS OF JAPAN vol. 15, no. 135 (E-1052)4 April 1991 & JP-A-30 16 159
- PATENT ABSTRACTS OF JAPAN vol. 9, no. 315 (E-365)11 December 1985 &JP-A-60 148 151
- PATENT ABSTRACTS OF JAPAN vol. 13, no. 571 (E-862)22 September 1989 &JP-A-12 38 148
- PATENT ABSTRACTS OF JAPAN vol. 12, no. 403 (E-674)26 October 1988 &JP-A-63 143 851
- PATENT ABSTRACTS OF JAPAN vol. 8, no. 200 (E-266)13 September 1984 &JP-A-59 088 864
- PATENT ABSTRACTS OF JAPAN vol. 11, no. 7 (E-469)9 January 1987 & JP-A-61 184 859

## Description

### BACKGROUND OF THE INVENTION

### FIELD OF THE INVENTION

The present invention relates generally to a semiconductor device. More particularly, the present invention relates to an improved structure of a semiconductor device wherein a semiconductor chip is mounted on a substrate by employing a flip chip process, and thereafter, both of the semiconductor chip and the substrate are sealed with a synthetic resin while they are incorporated in the semiconductor device.

### RELATED ART

Conventionally, various kinds of semiconductor devices have been hitherto produced and shipped such that a plurality of semiconductor units formed on semiconductor wafers or the like are cut into a number of semiconductor chips by employing a dicing process, and thereafter, each semiconductor chip is individually sealed in a package. Electrical connection of the semiconductor chip to the outside is achieved by using outer terminals secured to a substrate for the semiconductor chip or lead frames.

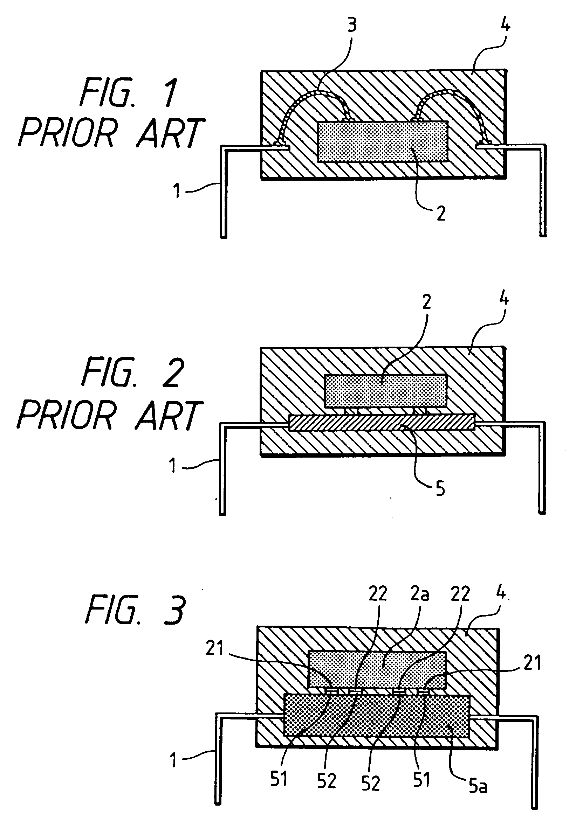

Fig. 1 is a sectional view illustrating a typical structure of a semiconductor device of the conventional type. As shown in Fig. 1, the semiconductor device is constructed such that outer terminals 1 are connected to a semiconductor chip 2 via wires 3 bonded to them, and thereafter, an assembly of the outer terminals 1, the semiconductor chip 2 and the wires 3 is sealed with a synthetic resin 4.

Fig. 2 is a sectional view illustrating the structure of another type of the conventional semiconductor device. As shown in Fig. 2, the semiconductor device is constructed such that after a semiconductor chip 2 is once mounted on a substrate 5 by employing a flip chip process, an assembly of the semiconductor chip 2 and the substrate 5 is sealed with a synthetic resin 4 while they are incorporated in the semiconductor device. Outer terminals 1 are previously secured to the substrate 5. thus, in this case, no bonding wire is used for the semiconductor device. The flip chip process is disclosed, for example, in "LSI Assembly Technique", Silver Series No. 12, pages 63 to 82, issued on March 31, 1987.

With respect to the semiconductor devices as constructed above, the synthetic resin 4 sealing the semiconductor chip 2 in the semiconductor device is used for the purpose of physically and chemically protecting the semiconductor chip 2. In practical use, however, the properties of the semiconductor device are deteriorated as time passes. In addition, it has been known that deterioration of the properties of the semiconductor device quickly proceed in a moist environment having an elevated temperature.

Document JP-A-59 088 864 discloses a LSI device comprising a master substrate and a slave substrate, the main surface of which is smaller then that of the master substrate. Both substrates are placed in opposing relationship and are connected by solder bumps together with a solder dam surrounding the functional element parts so that those element parts are hermetically sealed. Laminated layers of Ti and Pt are used, to provide a pattern on each substrate, to which the solder is subsequently applied.

### SUMMARY OF THE INVENTION

The present invention has been made in consideration of the foregoing problems inherent to the conventional art and, accordingly, an object of the invention is to provide an improved structure of a semiconductor device capable of improving durability that is, assuring that deterioration of the properties of the semiconductor device in the course of time can effectively be reduced.

This object is solved by a semiconductor device comprising the features of claim 1.

Advantageous embodiments are defined in the dependent claims.

According to an embodiment of the present invention, there is provided a semiconductor device including a substrate having terminals for electrical connection to the outside, a semiconductor chip mounted on the substrate by employing a flip chip process, and a synthetic resin for sealing the substrate and the semiconductor chip in the semiconductor device, wherein the semiconductor device includes a metallic pattern rectangularly formed on the functional surface of the semiconductor chip to completely surround the functional region on the semiconductor chip and a metallic pattern rectangularly formed on the substrate corresponding to the metallic pattern on the semiconductor chip, and that a gap between the semiconductor chip and the substrate is airtightly sealed with both the metallic patterns by connecting both the metallic pattern to each other when the semiconductor chip is mounted on the substrate.

A feature of the semiconductor device of the present invention consists in that the metallic pattern is disposed on the surface of the semiconductor chip mounted on the base board so that the substrate and the semiconductor chip are airtightly connected to each other by utilizing the foregoing metallic pattern.

With respect to the conventional semiconductor device, shielding of the semiconductor chip from the surrounding environment is achieved merely in reliance on a sealing synthetic resin. Things are same in case that a flip chip process is employed for mounting the semiconductor chip on the substrate, and a gap between the semiconductor chip and the substrate is filled with a sealing synthetic resin. However, since the sealing synthetic resin permits a small quantity of moisture or gas to practically permeate therethrough, integrated circuits and connection pads built on the surface of the semiconductor chip are unavoidably deteriorated due to the presence of moisture or the like in the environmental atmosphere.

In contrast with the conventional semiconductor device as mentioned above, the semiconductor device of one embodiment of the present invention is constructed such that the metallic pattern rectangularly formed with a closed route-shaped contour is disposed on the functional surface of the semiconductor chip (coincident with the lower surface of the same when the semiconductor chip is mounted on the substrate by employing a flip chip process) in such a manner as to surround the functional region on the semiconductor chip. On the other hand, the rectangular metallic pattern is disposed on the surface of the substrate corresponding to the rectangular metallic pattern on the semiconductor chip. When the semiconductor chip is mounted on the substrate, both the rectangular metallic patterns on the substrate and the semiconductor chip are connected to each other, whereby the functional region on the semiconductor chip is completely sealed with both the rectangular metallic patterns on the substrate and the semiconductor chip. Consequently, moisture or gas cannot reach the functional region on the semiconductor chip in spite of the fact that the sealing synthetic resin permits moisture or gas to permeate therethrough.

### BRIEF DESCRIPTION OF THE DRAWINGS

Fig. 1 is a sectional view illustrating a typical structure of a semiconductor device of the conventional type;
Fig. 2 is a sectional view illustrating the structure of another type of the conventional semiconductor device;
Fig. 3 is a sectional view of a semiconductor device in accordance with an embodiment of the present invention;
Fig. 4A shows a semiconductor chip used for the conventional semiconductor device;
Fig. 4B shows a semiconductor chip used for the semiconductor device of the present invention;
Fig. 5 is a perspective view showing the structure of the substrate for mounting the semiconductor chip according to the invention; and
Fig. 6 is an enlarged sectional view showing a structure of the metallic patterns 21 and 51 along with a bonding connection therebetween.

### DESCRIPTION OF THE PREFERRED EMBODIMENTS

Now, the present invention will be described in detail hereinafter with reference to the accompanying drawings which illustrates by way of example the structure of a semiconductor device in accordance with an embodiment of the present invention. However, it should be noted that this embodiment disclosed in the following manner is merely illustrative and the technical scope of the present invention should not be limited by description on the foregoing embodiment.

Fig. 3 is a sectional view of a semiconductor device in accordance with an embodiment of the present invention which illustrates by way of example the structure of the semiconductor device. It should be noted that same or similar parts or components to those shown in Fig. 2 are represented by same reference numerals.

As shown in the drawing, the semiconductor device is composed mainly of a substrate 5a, a semiconductor chip 2a mounted on the substrate 5a and a synthetic resin 4 with which an integral assembly of the substrate 5a and the semiconductor chip 2a is sealed in the semiconductor device. A rectangular extending metallic pattern 21 to be described later is formed on the mounting surface of the semiconductor chip 2a. A metallic pattern 51 is formed also on the mounting surface of the substrate 5a corresponding to the metallic pattern 21 of the semiconductor chip 2a. Thus, a gap between the semiconductor chip 2a and the substrate 5a is airtightly sealed by both the metallic patterns 21 and 51 on the semiconductor chip 2a and the substrate 5a. Outer terminals 1 are previously secured to the substrate 5a.

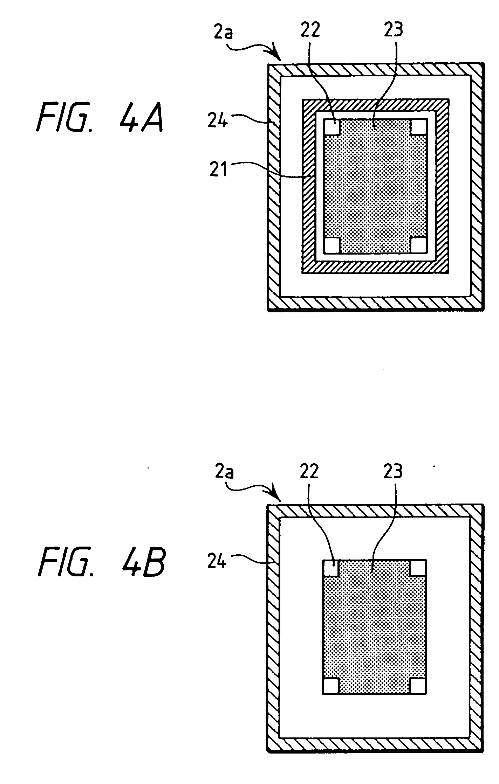

Fig. 4 is a diagrammatical view which illustrates the functional surface of the semiconductor chip 2a in the semiconductor device shown in Fig. 3 in comparison with the semiconductor chip 2a used for conventional semiconductor device.

As shown in Fig. 4B, the conventional semiconductor chip 2 includes a functional region 23 having integrated circuits and others, four pads 22, by way of which the functional region 23 is electrically connected to pads 52 on the substrate 5a, and a scribe line 24 for cutting the semiconductor chip 2 from a semiconductor wafer.

In contrast with the conventional semiconductor chip 2, as shown in Fig. 4A, the semiconductor chip 2a used for the semiconductor device of the present invention includes a functional region 23 having four pads 23 and a metallic pattern 21 rectangularly extending between the functional region 23 and a scribe line 24. As is apparent from the drawing, the functional region 23 is fully surrounded by the metallic pattern 21.

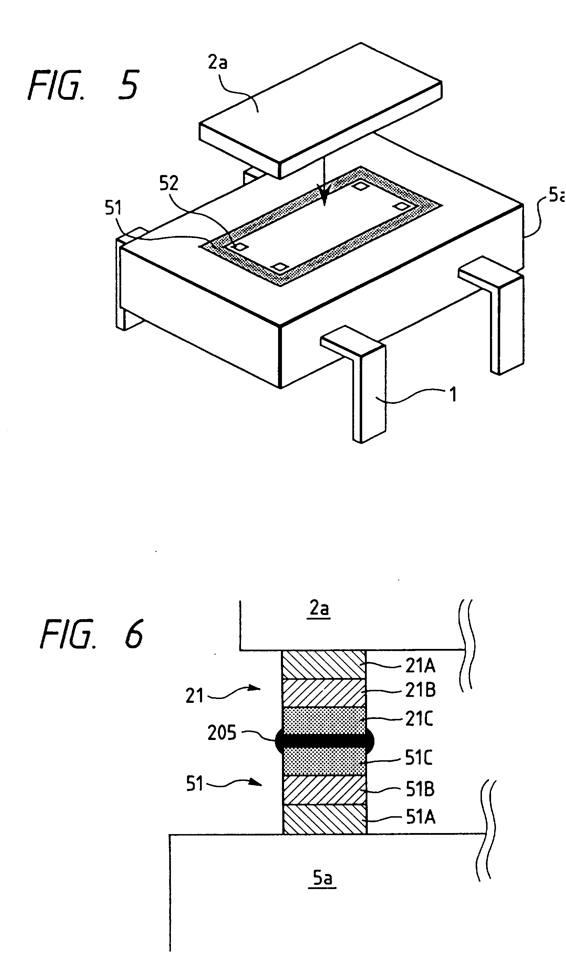

Fig. 5 is a perspective view showing the structure of the substrate for mounting the semiconductor chip 2a constructed in the above-described manner in the disassembled state.

As shown in Fig. 5, pads 52 corresponding to the pads 22 on the semiconductor chip 2a and a rectangularly extending metallic pattern 51 corresponding to the metallic pattern 21 are formed on the base board 5a. The pads 52 are electrically connected to the pads 22 of the semiconductor chip 2a so that signals transmit therethrough between the semiconductor chip 2a and the substrate 5a. The pads 52 are electrically connected to the outer terminals 1 extending outside of the substrate 5a.

Since the semiconductor chip 2a is mounted on the substrate 5a constructed in the above-described manner while its functional region faces the functional surface of the substrate 5a, the structure as shown in Fig. 3 is built. For the purpose of physical or electrical protection of the semiconductor chip 2a and easy handling of the same, the whole assembly of the substrate 5a and the semiconductor chip 2a is sealed with a synthetic resin 4 in the semiconductor device.

With the semiconductor device constructed as described above, since the functional region of the semiconductor chip 2a is completely sealably surrounded by a semiconductor wafer constituting the semiconductor chip 2a, the substrate 5a and the metallic patterns 21 and 51, there is no possibility that the functional region 23 on the semiconductor chip 2a is deteriorated in the presence of steam or the like.

Fig. 6 is an enlarged sectional view showing a structure of the metallic patterns 21 and 51 along with a bonding connection therebetween.

As shown in Fig. 6, the metallic pattern 21 of the semiconductor chip 2a is formed by three-layers consisting of a first layer 21A formed of Ti, second layer 21B formed of Pt and third layer 21C formed of Au. On the other hand, the metallic pattern 51 of the substrate 51 is formed by three-layers consisting of a first layer 51A formed of Ti, second layer 51B formed of Pd and third layer 51C formed of Au. As shown in the drawing, the third layer 21C of the semiconductor chip 2a faces the third layer 51 of the substrate 5a and bonded by adhesion 205 formed of AuSn containing 80% of Au and 20% of Sn. The metallic patterns 21, 51 thus formed are the best mode for a practical use because of a good durability and adhesibility. However, the invention is not limited thereto or thereby. The other material for each layer may be applicable if appropriate.

As described above, according to the present invention, since the semiconductor device is constructed such that a gap between the substrate and the semiconductor chip mounted on the substrate by employing a flip chip process is completely sealed by the metallic pattern formed on the substrate and the metallic pattern formed on the semiconductor chip, there is no possibility that the functional region on the semiconductor chip is deteriorated due to the presence of moisture or gas permeated through the sealing synthetic resin. Consequently, the semiconductor device has a long running life, and moreover, it can practically be used under a very severe environmental condition such as a moist working environment having an elevated temperature.

## Claims

1. A semiconductor device comprising:
a substrate (5a) comprising:
at least one outer terminal (1) extending to the outside of the semiconductor device;
at least one pad (52) formed on one surface of said substrate (5a) for electrically connecting to said outer terminal; and
a first metallic pattern (51) for surrounding said at least one pad, and a semiconductor chip (2a) mounted on said substrate (5a) by means of a flip chip process, said semiconductor chip comprising:
a functional region (23) facing said substrate;
at least one pad (22) provided on a position on said chip corresponding to said pad (52) of said substrate so that signals transmit through said pads (22, 52) between said semiconductor chip (2a) and said substrate (5a) when said chip is mounted on said substrate; and
a second metallic pattern (21) for surrounding said pad, said second metallic pattern (21) being fully and airtightly connected to said first metallic pattern (51) of said substrate to enclose and hermetically seal the functional region (23) of said chip (2a);
wherein said first metallic pattern (51) comprises a first substrate layer (51A) formed of Ti and connected to said surface of said substrate (5a),
said second metallic pattern (21) comprises a first chip layer (21A) formed of Ti and connected to said one surface of said semiconductor chip (2a) and a second chip layer (21B) formed of Pt, and
an adhesive layer (205) bonds said first and second metallic patterns,
**characterized in that**
said first metallic pattern (51) furthermore comprises a second substrate layer (51B) formed of Pd and a third substrate layer (51C) formed of Au,
said second metallic pattern (21) furthermore comprises a third chip layer (21C) formed of Au and facing that third substrate layer (51C), and
said adhesive layer (205) is formed of AuSn.

2. The semiconductor device of claim 1, wherein said substrate (5a) and said semiconductor chip (2a) are sealed by a synthetic resin (4).

3. The semiconductor device of claim 1, wherein said adhesion (205) AuSn contains 80% of Au and 20% of Sn.

## Patentansprüche

1. Halbleitereinrichtung, die umfaßt:
ein Substrat (5a), das umfaßt:
mindestens einen äußeren Anschluß (1), der sich zu der Außenseite von der Halbleitereinrichtung erstreckt;
mindestens eine Anschlußfläche (52), die auf einer Oberfläche von dem Substrat (5a) zur elektrischen Verbindung mit dem äußeren Anschluß gebildet ist; und
ein erstes metallisches Muster (51) zum Umgeben von der mindestens einen Anschlußfläche, wobei ein Halbleiterchip (2a) auf dem Substrat (5a) mittels eines Flip-Chip-Verfahrens angebracht ist, welches Halbleiterchip umfaßt:
einen funktionellen Bereich (23), der zum Substrat weist;
mindestens eine Anschlußfläche (22), die an einer Position auf dem Chip entsprechend der Anschlußfläche (52) von dem Substrat vorgesehen ist, so daß Signale über die Anschlußflächen (22, 52) zwischen dem Halbleiterchip (2a) und dem Substrat (5a) übertragen werden, wenn der Chip auf dem Substrat angebracht ist; und
ein zweites metallisches Muster (21) zum Umgeben von der Anschlußfläche, welches zweite metallische Muster (21) vollständig und luftdicht mit dem ersten metallischen Muster (51) von dem Substrat verbunden ist, um den funktionellen Bereich (23) von dem Chip (2a) zu umgeben und hermetisch zu verschließen;
wobei das erste metallische Muster (51) eine erste Substratschicht (51A) umfaßt, die aus Ti gebildet ist und mit der Oberfläche von dem Substrat (5a) verbunden ist,
das zweite metallische Muster (21) eine erste Chip-Schicht (21A), die aus Ti gebildet ist und mit der einen Oberfläche von dem Halbleiterchip (2a) verbunden ist, und eine zweite Chip-Schicht (21B) umfaßt, die aus Pt gebildet ist, und
eine Haftschicht (205) die ersten und zweiten metallischen Muster verbindet,
**dadurch gekennzeichnet,** daß
das erste metallische Muster (51) ferner eine zweite Substratschicht (51B), die aus Pd gebildet ist, und eine dritte Substratschicht (51C) umfaßt, die aus Au gebildet ist,
das zweite metallische Muster (21) ferner eine dritte Chip-Schicht (21C) umfaßt, die aus Au gebildet ist, und zu der dritten Substratschicht (51C) weist, und
die Haftschicht (205) aus AuSn gebildet ist.

2. Halbleitereinrichtung gemäß Anspruch 1, wobei das Substrat (5a) und das Halbleiterchip (2a) durch einen synthetischen Harz (4) verschlossen sind.

3. Halbleitereinrichtung gemäß Anspruch 1, wobei das Haftmittel (205) AuSn 80% Au und 20% Sn enthält.

## Revendications

1. Dispositif semi-conducteur comprenant
un substrat (5a) comprenant :
au moins une borne externe (1) s'étendant à l'extérieur du dispositif semi-conducteur ;
au moins une plage (52) formée sur une surface dudit substrat (5a) pour raccorder électriquement ladite borne externe ; et
un premier motif métallique (51) pour entourer ladite au moins une plage, et une puce semi-conductrice (2a) montée sur ledit substrat (5a) au moyen d'un procédé flip chip, ladite puce semi-conductrice comprenant :
une zone fonctionnelle (23) en regard dudit substrat ;
au moins une plage (22) placée sur une position sur ladite puce correspondant à ladite plage (52) dudit substrat pour que les signaux soit transmis à travers lesdites plages (22, 52) entre ladite puce semi-conductrice (2a) et ledit substrat (5a) lorsque ladite puce est montée sur ledit substrat ; et
un second motif métallique (21) pour entourer ladite plage, ledit second motif métallique (21) étant raccordé complètement et de façon étanche à l'air audit premier motif métallique (51) dudit substrat pour enfermer et sceller hermétiquement la zone fonctionnelle (23) de ladite puce (2a) ;
dans lequel ledit premier motif métallique (51) comprend une première couche de substrat (51A) formée de Ti et raccordée à ladite surface dudit substrat (5a),
ledit second motif métallique (21) comprend une première couche de puce (21A) formée de Ti et raccordée à ladite surface de ladite puce semi-conductrice (2a) et une seconde couche de puce (21B) formée de Pt, et
une couche adhésive (205) relie lesdits premier et second motifs métalliques,
caractérisé en ce que
ledit premier motif métallique (51) comprend de plus une seconde couche de substrat (51B) formée de Pd et une troisième couche de substrat (51C) formée de Au,
ledit second motif métallique (21) comprend de plus une troisième couche de puce (21C) formée de Au et en regard de cette troisième couche de substrat (51C), et
ladite couche adhésive (205) est formée de AuSn.

2. Dispositif semi-conducteur selon la revendication 1, dans lequel ledit substrat (5a) et ladite puce semi-conductrice (2a) sont enrobés par une résine synthétique (4).

3. Dispositif semi-conducteur selon la revendication 1, dans lequel ledit alliage AuSn de soudure (205) contient 80% de Au et 20% de Sn.
